# EUROPÄISCHE PATENTSCHRIFT

(11) **EP 1 625 614 B1**
(45) Veröffentlichungstag und Bekanntmachung des Hinweises auf die Patenterteilung: **01.05.2019**
(21) Anmeldenummer: 04722851.5
(22) Anmeldetag: 24.03.2004
(51) Int. Cl.: H01L 29/737, H01L 29/10, H01L 29/167

(54) **VERFAHREN ZUR HERSTELLUNG EINES BIPOLARTRANSISTORS**
METHOD FOR THE PRODUCTION OF A BIPOLAR TRANSISTOR
PROCEDE DE PRODUCTION D'UN TRANSISTOR BIPOLAIRE

(30) Priorität: 14.04.2003 DE 10317098
(43) Veröffentlichungstag der Anmeldung: 15.02.2006
(73) Patentinhaber: Infineon Technologies AG, 85579 Neubiberg (DE)
(72) Erfinder: BÖCK, Josef, 81827 München (DE); MEISTER, Thomas, 82024 Taufkirchen (DE); STENGL, Reinhard, 86391 Stadtbergen (DE); SCHÄFER, Herbert, 85635 Höhenkirchen-Siegertsbrunn (DE)
(74) Vertreter: Müller Hoffmann & Partner
(86) Internationale Anmeldenummer: PCT/EP2004/003125
(87) Internationale Veröffentlichungsnummer: WO 2004/090968

(56) Entgegenhaltungen:
- WO-A-98/26457
- WO-A-03/046947
- DE-A- 19 940 278
- US-B1- 6 368 946
- US-B1- 6 406 966
- US-B1- 6 541 336
- MEISTER T F ET AL: "SiGe base bipolar technology with 74 GHz fmax and 11 ps gate delay" ELECTRON DEVICES MEETING, 1995., INTERNATIONAL WASHINGTON, DC, USA 10-13 DEC. 1995, NEW YORK, NY, USA,IEEE, US, 10. Dezember 1995 (1995-12-10), Seiten 739-742, XP010161097 ISBN: 0-7803-2700-4 in der Anmeldung erwähnt
- KING C A ET AL: "Very low cost graded SiGe base bipolar transistors for a high performance modular BiCMOS process" ELECTRON DEVICES MEETING, 1999. IEDM TECHNICAL DIGEST. INTERNATIONAL WASHINGTON, DC, USA 5-8 DEC. 1999, PISCATAWAY, NJ, USA,IEEE, US, 5. Dezember 1999 (1999-12-05), Seiten 565-568, XP010372173 ISBN: 0-7803-5410-9
- ABDUL-RAHIM A I ET AL: "Improved control of polysilicon emitter interfacial oxide using a UHV-compatible LPCVD cluster tool" IEEE MTT/ED/AP/LEO SOCIETIES JOINT CHAPTER UNITED KINGDOM AND REPUBLIC OF IRELAND SECTION. WORKSHOP ON HIGH PERFORMANCE ELECTRON DEVICES FOR MICROWAVE AND OPTOELECTRONIC APPLICATIONS. EDMO, XX, XX, 24. November 1997 (1997-11-24), Seiten 232-236, XP002156028

## Beschreibung

Die vorliegende Erfindung betrifft ein Verfahren zur Herstellung eines Bipolartransistors.

Obwohl prinzipiell auf beliebige Bipolartransistoren anwendbar, werden die vorliegende Erfindung und die ihr zugrundeliegende Problematik in Bezug auf DPSA-Transistoren erläutert.

DPSA(selbstjustierte Doppel-Polysilizium)-Transistoren, wie z.B. aus T.F. Meister et al., IEDM Technical Digest 1995, p.739-741 bekannt, verwenden als p⁺-Basisanschluss sowie als n⁺-Emitterkontakt eigens hierfür abgeschiedene p⁺-Polysilizium- bzw. n⁺-Polysiliziumschichten. Dabei ist im Emitterfenster die n⁺-Polysilizium-Emitterschicht selbstjustiert durch einen Spacer von der p⁺-Polysiliziumschicht des Basisanschlusses isoliert. Aufgrund ihrer lateralen und vertikalen Skalierbarkeit und den geringen parasitären Kapazitäts- und Widerstandsanteilen ist die DPSA-Transistorstruktur für Höchstgeschwindigkeitsanwendungen am besten geeignet. Der DPSA-Transistor kann dabei sowohl eine implantierte Si-Basis als auch eine epitaktisch abgeschiedene SiGe-Basis enthalten.

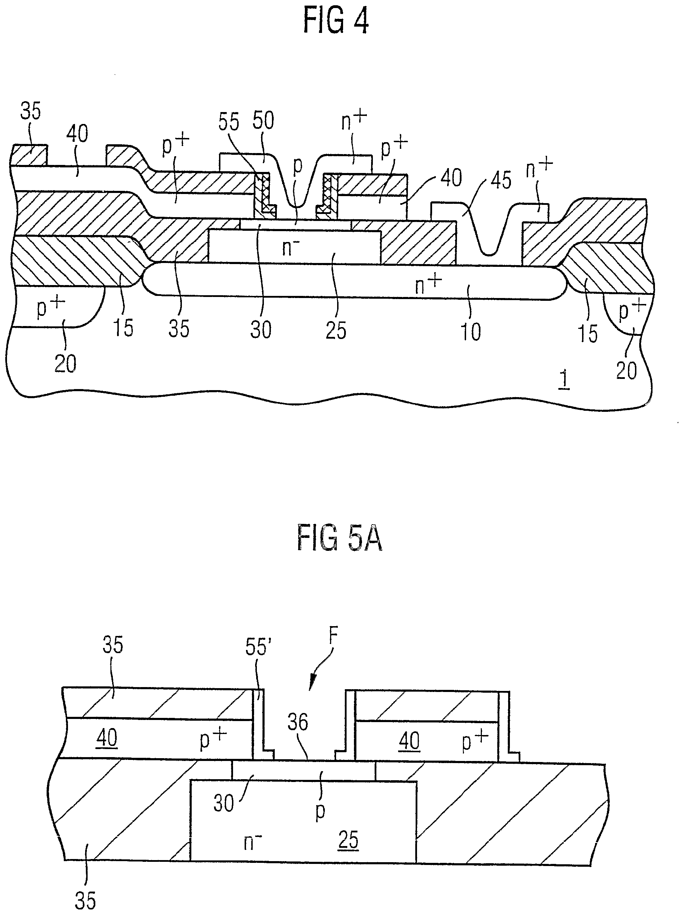

Fig. 4 ist eine schematische Darstellung eines bekannten DPSA-Transistors, wie aus T.F. Meister et al., IEDM Technical Digest 1995, p.739-741 bekannt.

In Fig. 4 bezeichnet Bezugszeichen 1 ein Silizium-Halbleitersubstrat, 10 einen n⁺-Subkollektorbereich in Form einer vergrabenen Schicht, 20 p⁺-Kanalsperrbereiche, 25 einen n⁻-Kollektorbereich, 30 einen p-Basisbereich, 35 eine CVD-Isolationsoxidschicht, 15 eine LOCOS-Isolationsoxidschicht, 40 einen p⁺-Basisanschluss, 45 einen n⁺-Kollektorkontakt, 55 einen Doppel-Spacer aus Siliziumoxid/Siliziumnitrid, und 50 einen n⁺-Emitterkontakt.

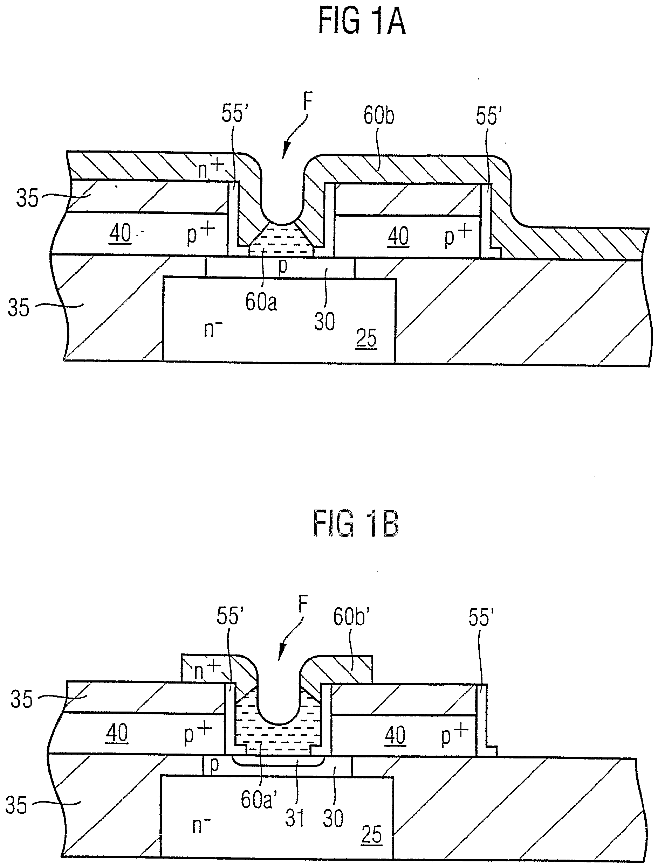

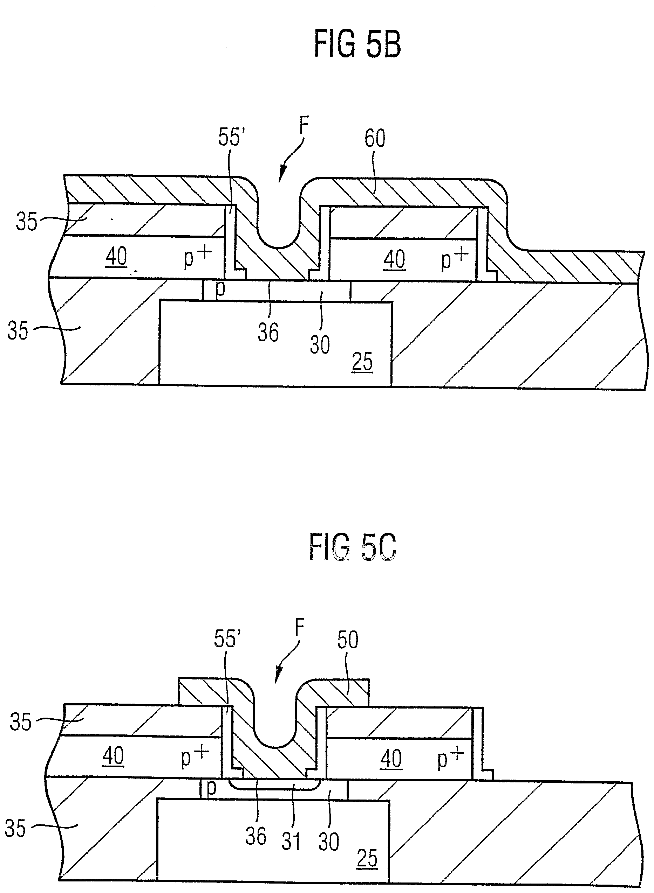

Fig. 5a-c sind schematische Darstellungen der Verfahrensschritte hinsichtlich des Emitterkontakts eines üblichen Verfahren zur Herstellung eines DPSA-Transistors, wobei im Unterschied zu Fig. 1 Bezugszeichen 55' einen Einfachspacer aus Oxid bezeichnet. Bezugszeichen F bezeichnet das Emitterfenster in den Schichten 35 und 40.

Zur Herstellung des n⁺-Emitterkontakts wird beim DPSA-Transistor nach der Bildung des Oxidspacers 55', der die Seitenwände des Emitterfensters F bedeckt auf dem aktiven p⁺-Basisbereich eine n⁺-dotierte (implantiert oder in-situ dotiert) n⁺-Polysiliziumschicht 60 auf dem aktiven Transistorgebiet sowie auf den umliegenden Isolationsbereichen polykristallin aufgebracht.

Danach wird die n⁺-Polysiliziumschicht 60 zur Bildung des endgültigen Emitterkontakts 60 mittels einer Fototechnik anisotrop strukturiert und mit einem Temperaturschritt der n⁺-Dotierstoff z.B. 20 nm in das darunter liegende einkristalline Si-Material des Basisbereichs 30 eingetrieben (Fig. 5c). Auf diese Weise entsteht ein n⁺-Emitter, der sich aus einem monokristallinen Anteil 31 und einem polykristallinen Anteil 50 zusammensetzt.

Bei diesem Herstellverfahren bildet sich in der Zeit zwischen Spacerätzung und n⁺-Polysilizium-Emitterabscheidung auf dem aktiven Transistorgebiet zwischen dem mono- und polykristallinern Teil des Emitters ein natürlicher Oxidfilm 36 von 0.5- 2 nm aus. Die Dicke dieser nur äusserst schwierig zu kontrollierenden, natürlichen Oxidschicht 36 beeinflusst sowohl empfindlich die Stromverstärkung als auch den Emitterwiderstand des DPSA-Transistors.

Bei DPSA-Transistoren mit implantierter Si-Basis war das natürliche Grenzschichtoxid 36 notwendig, um eine ausreichend hohe Stromverstärkung zu erreichen. Dagegen ist im Falle einer integrierten SiGe-Basis die natürliche Oxidschicht 36 nicht mehr notwendig, da solche DPSA-Transistoren allein aufgrund des Ge-Gehalts in der Basis schon ausreichend hohe Stromverstärkungen erreichen. Zudem macht sich mit zunehmender lateraler Skalierung des Emitterfensters F in diesen DPSA-Transistoren das Ansteigen des Emitterwiderstandes immer stärker nachteilig bemerkbar. Dieses Ansteigen des Emitterwiderstandes führt nämlich zu einer deutlichen Reduktion in der Grenzfrequenz und begrenzt heute die laterale Skalierbarkeit des DPSA-Transistors.

Ursachen hierfür sind das besagte natürliche Grenzschichtoxid 36 in der poly/mono-Zwischenschicht des n⁺-Emitters als auch die begrenzte Leitfähigkeit der n⁺-Polysiliziumschicht im engen Emitterfenster F des DPSA Transistors.

Auf der anderen Seite sind vom DPSA Transistor abweichende Si-Ge-Bipolartransistorstrukturen bekannt, bei denen der integrierte n⁺-Emitter gänzlich monokristallin ist (siehe H.U. Schreiber et al., Electronic Letters 1989, Vol. 25, p. 185-186.

So wird gemäß H.U. Schreiber et al. ein sogenannter Doppel-Mesa-Transistor beschrieben, zu dessen Herstellung auf einer blanken Si-Scheibe in einem einzigen Epitaxieschritt zunächst der n⁻-dotierte Kollektor, die SiGe-Basis, ein n⁻-dotierter Epitaxieemitter und ein n⁺-dotiertes monokristallines Emittercap aufgebracht werden. Danach werden die aufgebrachten Epitaxieschichten strukturiert und mittels einer Metallisierung geeignet kontaktiert. Im Vergleich zum DPSA-Transistor weist der Doppel-Mesa-Transistor deutlich grössere laterale Abmessungen auf, die die Schaltungsperformance dieser Transistorstruktur begrenzen. So muss z.B. in dieser Transistorstruktur die laterale, effektive Emitterweite immer grösser als das den Emitter kontaktierende Kontaktloch sein.

Ebenso wird gemäß der US 6,177,717 B1 ein single-poly(SP)-Transistor beschrieben, bei dem der n⁺-dotierte Emitterbereich monokristall in einem CVD-Reaktor auf die SiGe-Basis abgeschieden wird. Auch solche SP-Transistoren haben im Vergleich zur DPSA-Transistorstruktur deutliche Nachteile. Z.B. fehlt die zusätzliche p⁺-Polysiliziumabscheidung (Dicke ca. 100-200 nm), die beim DPSA-Transistor zur Reduktion des Basis-Anschlusswiderstandes durchgeführt wird. Deshalb hat der SP-Transistor zwar eine planarere Topologie im Emitterfenster, erfordert aber nach der SiGe-Basisabscheidung zur Verbesserung des Basis-Bahnwiderstandes noch eine p⁺-Implantation in das monokristalline SiGe-Basisanschlussgebiet. Diese p⁺-Implantation erzeugt Punktdefekte, die während der nachfolgenden Prozessschritte in die nahegelegene aktive Basis diffundieren und dort zu einer deutlichen Verbreiterung des vertikalen Basisprofils und damit zu einer deutlichen Reduktion der Grenzfrequenz führen. In dieser planaren Transistorstruktur wurde der monokristallin abgeschiedene n⁺-Emitter (im Vergleich zum n⁺-poly/mono-Emitter) zur Verbesserung des Niederfrequenzrauschens eingeführt.

Die Druckschrift US 6,541,336 B1 offenbart ein Herstellungsverfahren für einen Bipolartransistor, bei dem innerhalb einer in einer Isolationsschicht gebildeten Emitteröffnung ein natürliches Oxid von einer darunterliegenden Basisschicht entfernt wird.

Die Druckschrift DE 199 40 278 A offenbart ein Verfahren zur Herstellung einer Schichtstruktur für Bipolartransistoren, welche eine partiell-einkristalline Emitterschicht enthält.

Die Druckschrift King C.A. et al.: "Very Low Cost Graded SiGe Base Bipolar Transistor for a High Performance Modular BiCMOS Process", Electron Devices Meeting, 1999, IEDM Technical Digest, S. 565-568 offenbart ein Verfahren zum Herstellen eines SiGe-Bipolartransistors, welches Hochenergieimplantieren zur Ausbildung der Subkollektorregion aufweist.

Die Druckschrift WO 98/26457 A offenbart, wie die Diffusion von Bor in SiGe unterdrückt werden kann, wenn ein zusätzliches elektrisch inaktives Material wie beispielsweise Kohlenstoff verwendet wird.

Aufgabe der Erfindung ist es, ein verbessertes Verfahren zur Herstellung eines Bipolartransistors anzugeben, wobei der Emitterwiderstand möglichst niedrig gehalten werden kann.

Diese Aufgabe wird durch ein Verfahren eines Bipolartransistors nach Anspruch 1 gelöst.

Die vorliegende Erfindung schafft ein Herstellungsverfahren für einen Bipolartransistor, bei dem sowohl die poly/mono-Si-Grenzschicht als auch der darin enthaltene natürliche Oxidfilm nicht mehr vorhanden sind, so dass Transistoren mit möglichst kleinem Emitterwiderstand hergestellt werden können.

Bevorzugte Weiterbildungen sind Gegenstand der Unteransprüche.

Gemäß einer weiteren bevorzugten Weiterbildung ist der Temperschritt ein schneller Annealschritt, vorzugsweise ein Lampenannealschritt.

Gemäß einer weiteren bevorzugten Weiterbildung wird zwischen dem Kollektorbereich und dem Basisanschlussbereich ein zweiter Isolationsbereich vorgesehen, der mittels einer nasschemischen Ätzung im Fenster geöffnet wird, bevor der Basisbereich selektiv im Emitterfenster auf dem Kollektorbereich gebildet wird.

Erfindungsgemäß wird der Basisbereich ganzflächig über dem Halbleitersubstrat mit einem darin eingebetteten, nach oben freiliegenden Kollektorbereich abgeschieden, wobei über dem Basisbereich ein Maskenbereich entsprechend dem späteren Emitterfenster gebildet wird, der in den Basisanschlussbereich und den darüber liegenden ersten Isolationsbereich eingebettet wird, wonach das Fenster gebildet wird.

Gemäß einer weiteren bevorzugten Weiterbildung wird der Basisanschlussbereich mittels selektiver Epitaxie in situ dotiert über dem Basisbereich aufgewachsen.

Gemäß einer weiteren bevorzugten Weiterbildung weist der Maskenbereich eine Oxidschicht und eine darüber liegende Nitridschicht auf, wobei die Nitridschicht beim Bilden des Fensters entfernt wird, der erste Seitenwandspacer im Fenster auf der Oxidschicht gebildet wird, und dann die Oxidschicht mittels einer nasschemischen Ätzung geöffnet wird.

Erfindungsgemäß weist der Basisbereich eine untere höher dotierte erste Basisgrundschicht und eine obere niedriger dotierte Basiskappenschicht auf, über der der Basisanschlussbereich vorgesehen ist, wobei die Basiskappenschicht beim Temperschritt von dem Basisanschlussbereich aufdotiert wird.

Dabei wird die Basiskappenschicht nach dem Bilden des Maskenbereichs gedünnt. Dies gewährleistet ein sicheres Aufdotieren.

Gemäß einer weiteren bevorzugten Weiterbildung geschieht das Entfernen des natürlichen Oxids im freigelegten Basisbereich in einem Epitaxiereaktor durch eine Temperung in Wasserstoffatmosphäre und wird das differentielle Abscheiden der Emitterschicht anschließend in situ im Epitaxiereaktor durchgeführt.

Nachfolgend wird die Erfindung anhand von Ausführungsbeispielen unter Bezugnahme auf die Zeichnungen näher erläutert.

Es zeigen:
Fig. 1a,b schematische Darstellungen der Verfahrensschritte hinsichtlich des Emitterkontakts eines ersten beispielhaften Verfahrens zur Herstellung eines DPSA-Transistors;
Fig. 2a-g schematische Darstellungen der Verfahrensschritte eines zweiten beispielhaften Verfahrens zur Herstellung eines DPSA-Transistors;
Fig. 3a-g schematische Darstellungen der Verfahrensschritte einer erfindungsgemäßen Ausführungsform des Verfahrens zur Herstellung eines DPSA-Transistors;
Fig. 4 eine schematische Darstellung eines bekannten DPSA-Transistors; und
Fig. 5a-c schematische Darstellungen der Verfahrensschritte hinsichtlich des Emitterkontakts eines üblichen Verfahrens zur Herstellung eines DPSA-Transistors.

In den Figuren gleiche Bezugszeichen bezeichnen gleiche oder gleich wirkende Elemente.

Fig. 1a,b sind schematische Darstellungen der Verfahrensschritte hinsichtlich des Emitterkontakts eines ersten beispielhaften Verfahrens zur Herstellung eines DPSA-Transistors.

Prinzipiell wird hier ein Verfahren angegeben, das im aktiven Emitterbereich und dessen Umgebung die n⁺-Polysilizium-Emitterschicht 60 des DPSA-Transistors durch eine monokristalline n⁺-Emitterschicht 60a' ersetzt.

Hierzu wird ausgehend vom in Fig. 5a gezeigten Prozesszustand zunächst in einem ultrasauberen Epitaxiereaktor der natürliche Oxidfilm 36 auf dem freiliegenden Silizium des Basisbereichs 30 am Boden vom Emitterfenster F mit einer Temperung (mindestens 800 °C) in H2-Atmosphäre entfernt. Anschliessend wird im Epitaxiereaktor mittels differentieller Epitaxie die n⁺-dotierte Emitterschicht 60a,b in-situ mit As oder P dotiert (z.B. 1×10²⁰ cm⁻³ - 1×10²¹ cm⁻³) ganzflächig abgeschieden. Dabei wächst die n⁺-Emitterschicht auf den freiliegenden Siliziumbereichen als monokristalliner Emitterbereich 60a und auf den umgebenden Oxidbereichen als polykristalliner Emitterbereich 60b auf, wie in Fig. 1a dargestellt. Als Siliziumquelle für diese Niedertemperaturabscheidung (bei ca. 450 °C - 650 °C) kann z.B. Disilan verwendet werden.

Um eine Ausdiffusion des Borprofils in der darunter liegenden SiGe-Basis 30 während der nachfolgenden Temperaturschritte weitestgehend zu vermeiden, kann während dieser Abscheidung der n⁺-Emitterschicht 60a,b auch Kohlenstoff (C) mit einer Konzentration von 1×10¹⁹ cm⁻³ - 2×10²⁰ cm⁻³ in die n⁺-dotierte Emitterschicht 60a,b eingebracht werden. Der eingebrachte C kann die z.B. in hoch As dotierten Si Schichten erzeugten Punktdefekte binden und so verhindern, dass sie in die SiGe-Basis 30 diffundieren und dort zu einer anomal hohen Bordiffusion führen.

Im Besonderen ist das Einbringen von C beim monokristallinem Emitter von grossem Vorteil, da hier die n⁺-poly/mono-Grenzschicht fehlt, welche eine Barriere für Punktdefekte darstellt.

Nach dieser ganzflächigen n⁺-Emitter-Abscheidung wird die n⁺-Schicht 60a, 60b in einem Fotoschritt zum endgültigen Emitterkontakt 60a', 60b' strukturiert und ein kurzer Lampenausheilschritt (z.B. 980° C, 4 s) zur Aktivierung des n⁺-Dotierstoffs durchgeführt, wie in Fig. 1b gezeigt.

Während dieses Temperaturschrittes diffundiert der n⁺-Dotierstoff einige nm in das Si-Material der SiGe-Basis 30 unter der aufgebrachten n⁺-Epitaxieschicht ein. Des weiteren führt dieser Temperaturschritt zu einer teilweisen Rekristallisation des n⁺-dotierten polykristallinen Materials auf den Seitenwandbereichen des Emitterfensters F. Mit anderen Worten bildet sich der monokristalline Emitterbereich 31 in einem Teil des früheren Basisbereichs 30, und der monokristalline Emitterbereich 60a vergrössert sich zum monokristallinen Emitterbereich 60a', der die Seitenwand mit dem Oxidspacer 55' des Emitterfensters F grösstenteils bedeckt.

Dieses Verfahren vermeidet damit eine poly/mono-Silizium-Grenzschicht am Boden des Emitterfensters F und das in ihr vorhandene Grenzschichtoxid 36 . Aus diesem Grund kann mit diesem Verfahren der Emitterwiderstand des lateral skalierten DPSA-Transistors signifikant reduziert werden. Des weiteren ist im Vergleich zu einer n⁺-Polysiliziumschicht gleicher Dicke der Schichtwiderstand der monokristallinen n⁺-Siliziumschicht 60a' im Emitter um einen Faktor 3 oder mehr reduziert. Dies ist ebenfalls von grossem Vorteil, um im engen Emitterfenster F des DPSA-Transistors mit einem ungünstigen Aspektverhältnis einen möglichst niedrigen Emitterwiderstand zu erreichen.

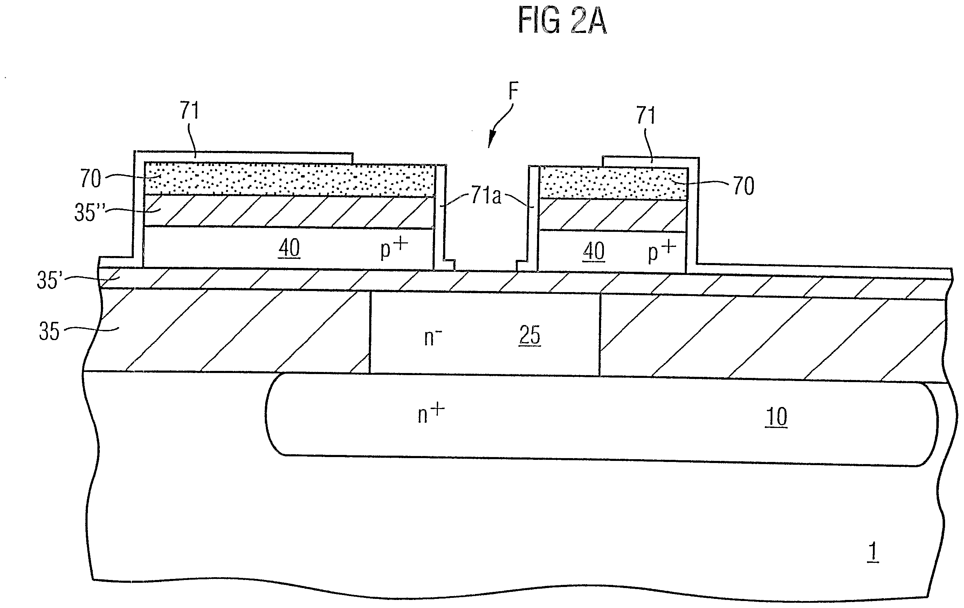

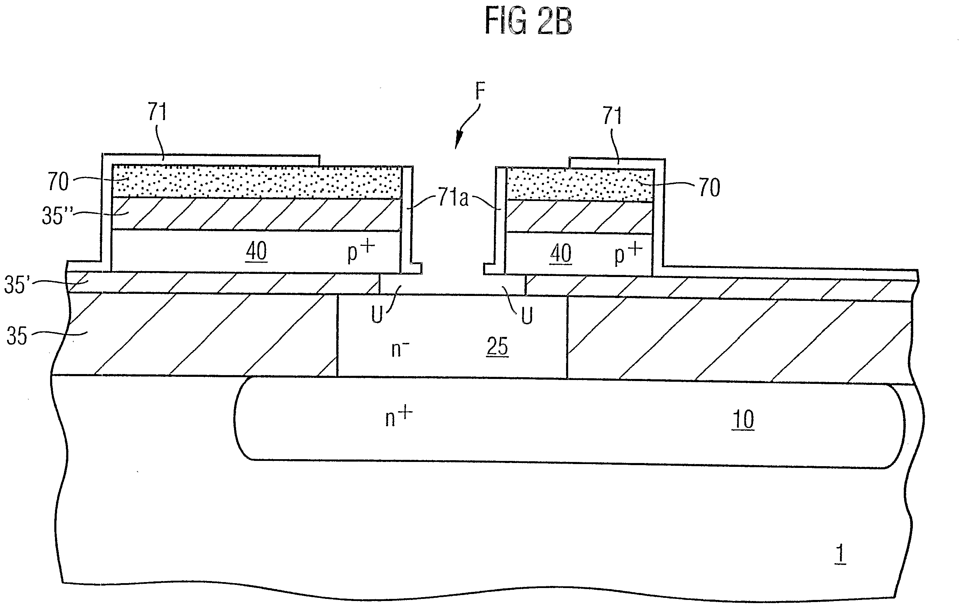

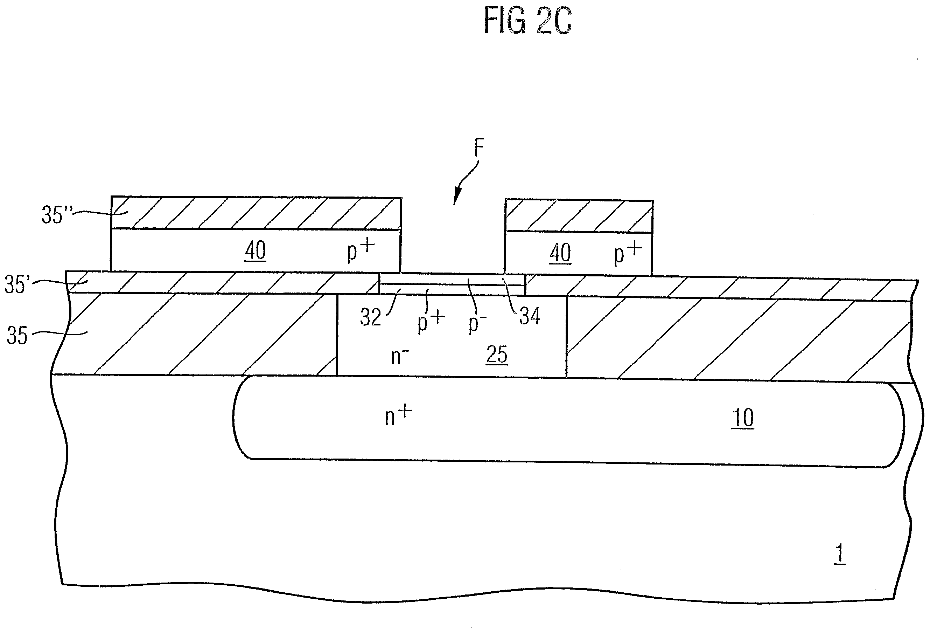

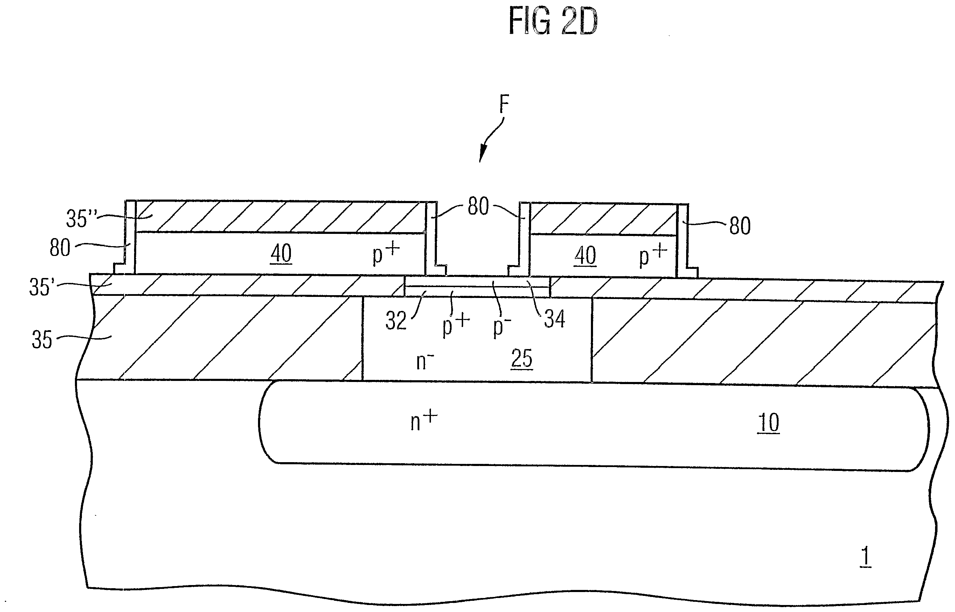

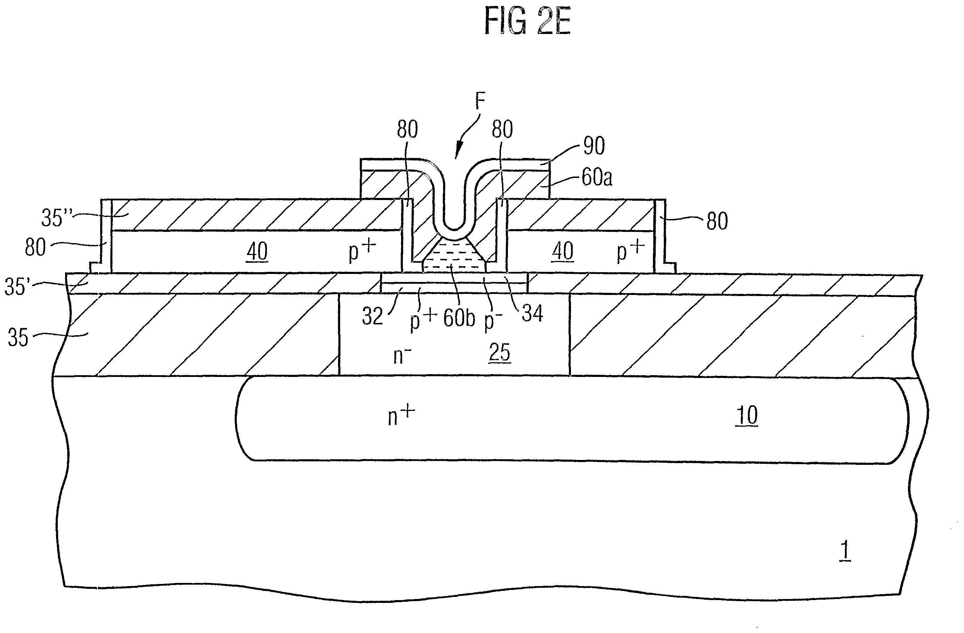

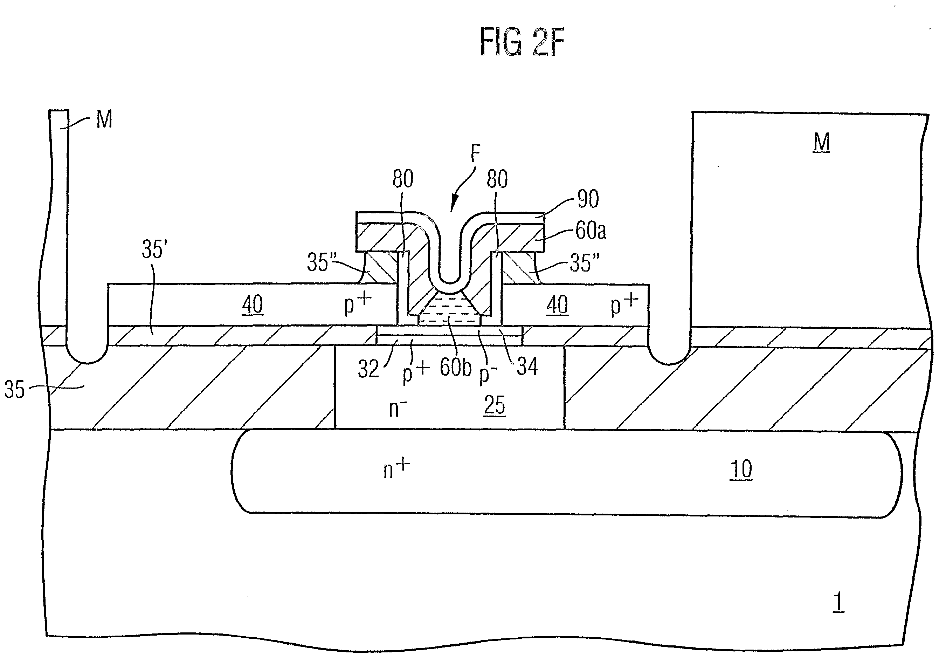

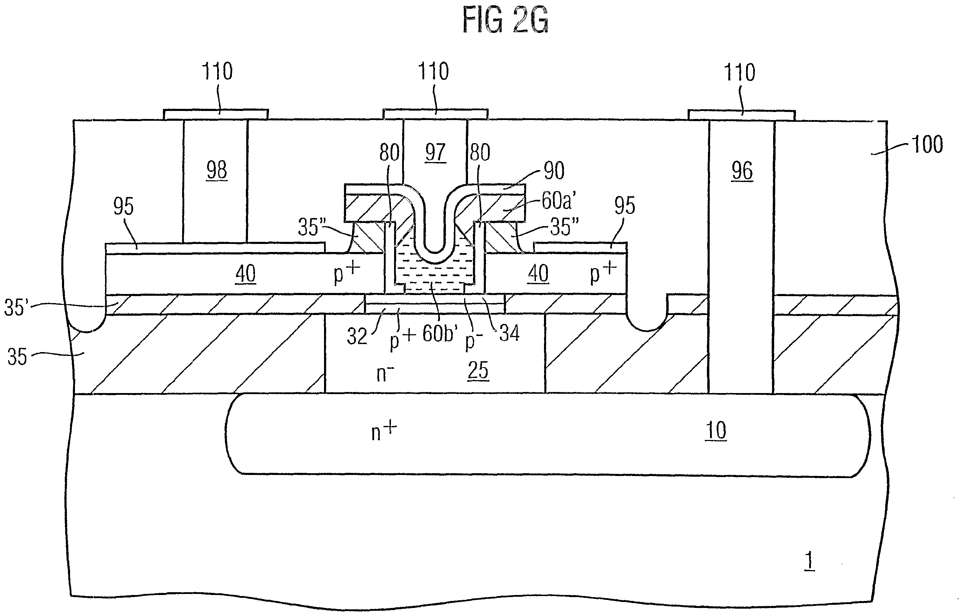

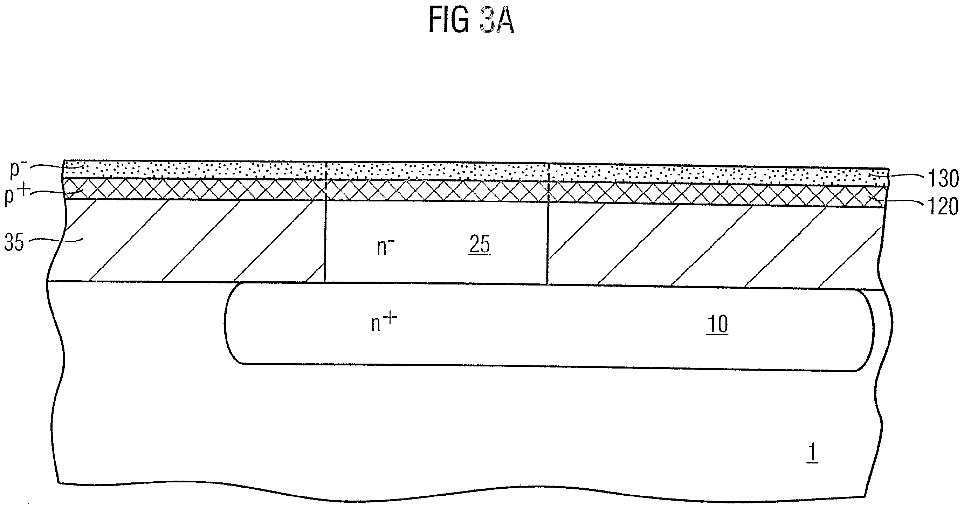

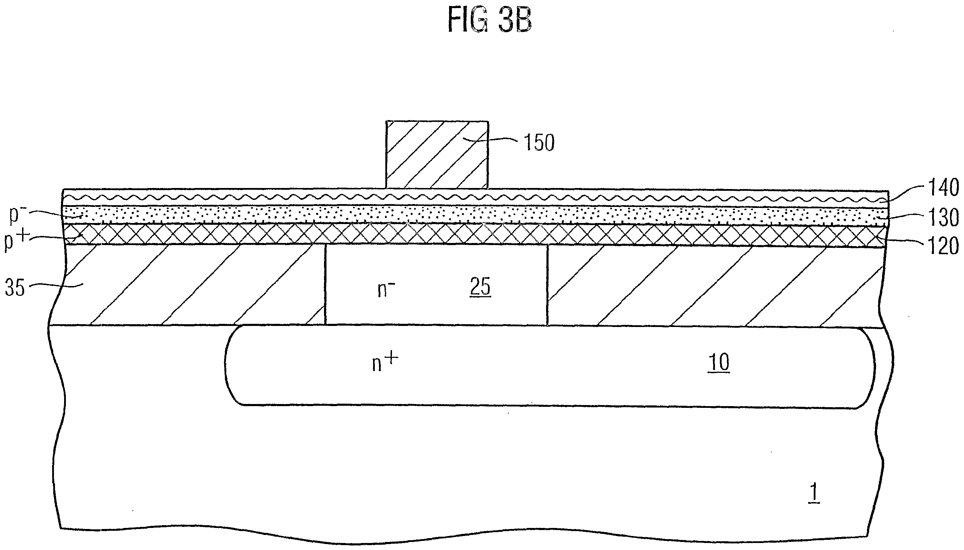

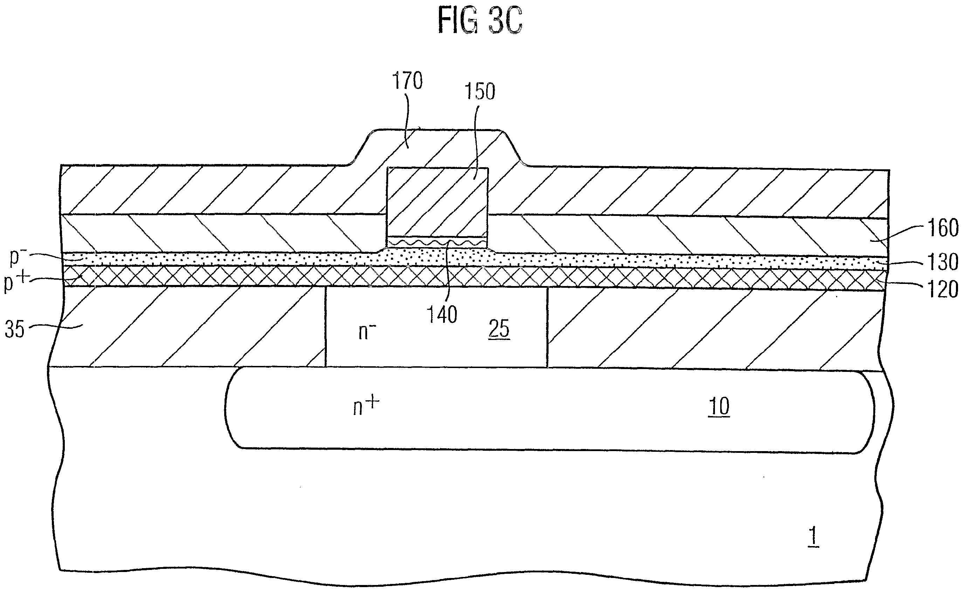

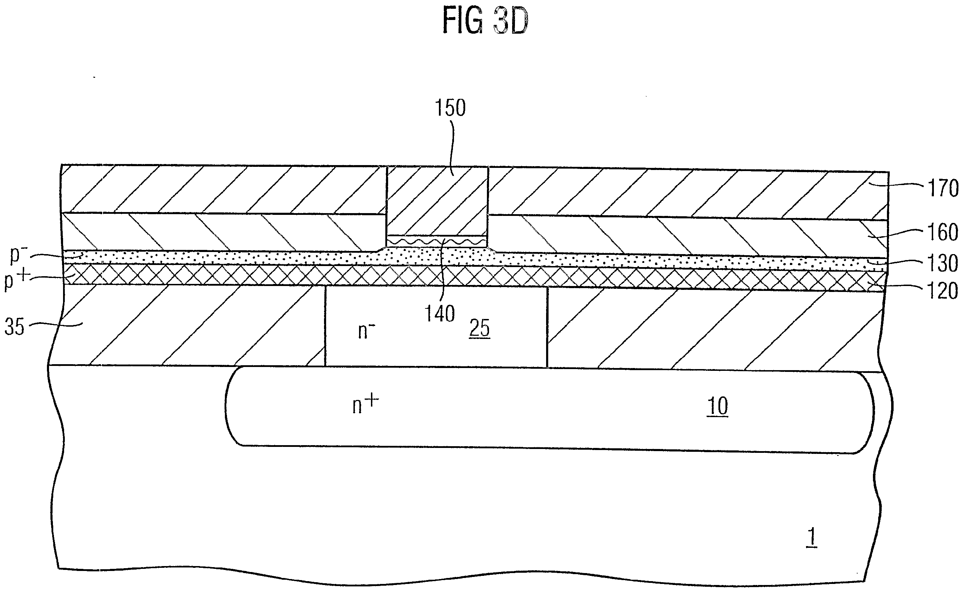

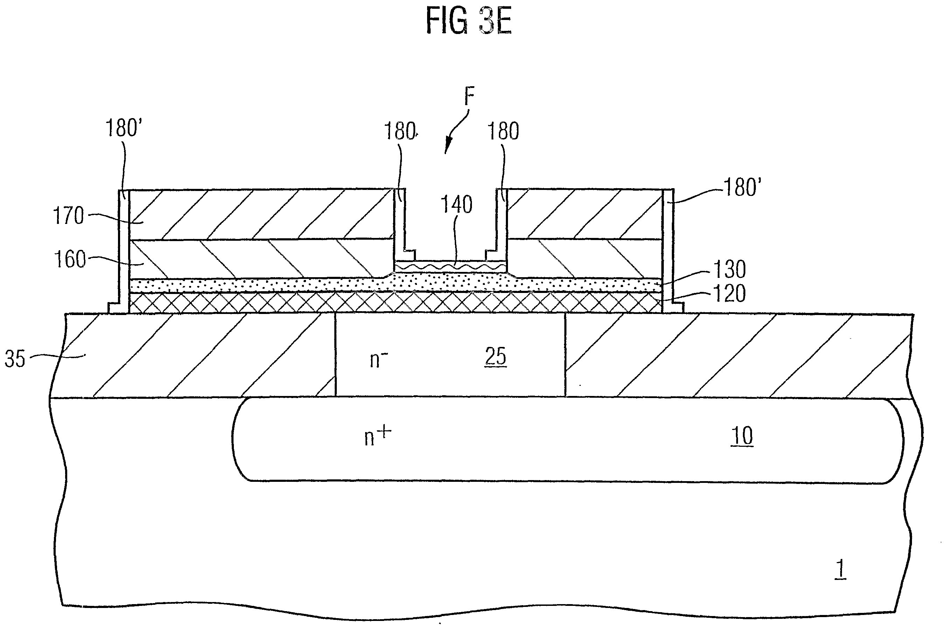

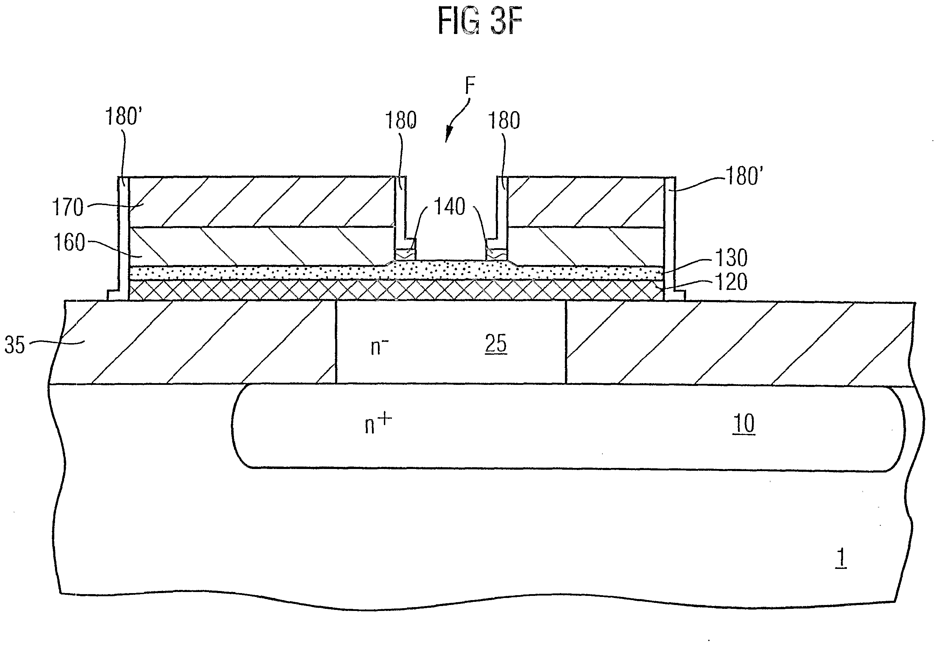

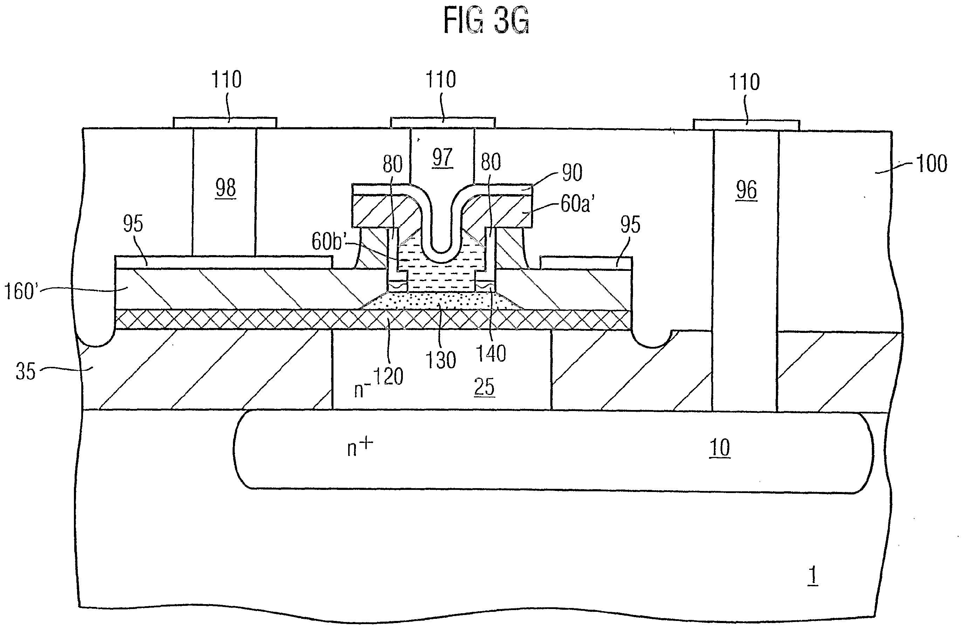

Im folgenden werden zuerst, mit Bezug auf Fig. 2, ein weiteres Beispiel und danach, mit Bezug auf Fig. 3, ein Ausführungsbeispiel der Erfindung eines DPSA-Transistors für die Integration eines n⁺-dotierten monokristallinen Emitters nach obigem Verfahren detailliert beschrieben. Dabei handelt es sich um einen mittels selektiver SiGe-Basis-Epitaxie und um einen mittels ganzflächiger SiGe-Basis-Epitaxie hergestellten DPSA-Transistor.

Fig. 2a-g sind schematische Darstellungen der Verfahrensschritte eines zweiten beispielhaften Verfahrens zur Herstellung eines DPSA-Transistors.

Ein bekanntes Herstellungsverfahren für den mittels selektiver SiGe-Basis-Epitaxie hergestellten DPSA-Transistor ist z.B. in der DE 199 58 062 C2 ausführlich beschrieben. Es werden hier die zum Verständnis des Ausführungsbeispiels wichtigsten Herstellungsschritte beginnend mit der selektiven Basisabscheidung erläutert.

Fig. 2a zeigt den Zustand des DPSA-Transistors vor der Integration der SiGe-Basis. Als Isolation wird hier z.B. die bekannte Shallow-Trench-Isolation verwendet. Bei dieser planaren Isolation ist der n⁻-dotierte Kollektor 25 lateral durch die CVD-Oxidbereiche 35 isoliert. Der n⁻-dotierte Kollektor 25 liegt auf dem niederohmigen, hoch As-dotierten Subkollektor 10. Der n⁻-Kollektor 25 wird von einem 40-80 nm dicken CVD-Oxidschicht 35' abgedeckt. Auf der CVD-Oxidschicht 35' ist ein Stack bestehend aus dem p⁺-Polysilizium-Basisanschluss 40, einer weiteren CVD-Oxidschicht 35" und einer Nitridschicht 70 strukturiert. Die Seitenwände des oberhalb des n⁻-dotierten Kollektors 25 gelegenen Emitterfensters F werden von einem dünnen Nitridspacer 71a bedeckt. Die zur Herstellung dieses Spacers 71a verwendete Nitridschicht 71 dient gleichzeitig dazu, die ausserhalb des Emitterfensters F gelegenen Isolationsbereiche der CVD-Oxidschicht 35' vor der nachfolgenden Nassätzung zu schützen.

Mittels dieser Nassätzung wird, wie in Fig. 2b gezeigt, die CVD-Oxidschicht 35' im Emitterfenster F selektiv zu dem umgebenden Nitridspacer 71a entfernt. Diese isotrope Ätzung wird solange durchgeführt, bis selbstjustiert ein p⁺-Polysilizium-Überhang U von ca. 80 nm entstanden ist.

Die p⁺-dotierte SiGe-Basis 32 und die niedrig dotierte Si-Kappe (n- oder p-) 34 werden in einem CVD-Reaktor mittels selektiver Epitaxie auf dem freiliegenden Siliziumbereich des n⁻-Kollektors 25 abgeschieden, wie in Fig. 2c gezeigt.

Bei der selektiven Epitaxie wird in der p⁺-dotierten SiGe-Basis auch C (1×10¹⁸ cm⁻³ - 1×10²⁰ cm⁻³) gemäß Fig. 2c eingebaut, um die Diffusion der Boratome während der nachfolgenden Prozessschritte weitestgehend zu vermeiden. Die selektive Abscheidung der SiGe/Si-Schichten 32, 34 wird solange durchgeführt, bis ein niederohmiger Kontakt mit dem freiliegenden p⁺-Polysilizium des Basisanschlusses erreicht ist. Danach werden die Nitridspacer 71a und die anderen Nitridhilfsschichten 70, 71 in Phosphorsäure selektiv zu Oxid und Si entfernt.

Danach werden gemäß Fig. 2d Oxidspacer 80 an den Seitenwänden des Emitterfensters F angebracht, die später den p⁺-Basisanschluss 40 von den n⁺-dotierten Emitterbereichen isolieren bzw. die anderen Seitenkanten des p⁺-Basisanschlusses 40 bei der Abscheidung des n⁺-dotierten Emitterpolysiliziums schützen.

Dann wird gemäß Fig. 2e analog zu dem in Fig. 1a,b Beschriebenen die n⁺-dotierte Emitterschicht 60a,b in einem CVD-Reaktor ganzflächig mittels differentieller Epitaxie abgeschieden. Dabei wächst die n⁺-dotierte Emitterschicht auf den freiliegenden Siliziumbereichen als monokristalliner Emitterbereich 60a und auf den Oxidbereichen als polykristalliner Emitterbereich 60b auf.

Hierbei ist es, wie gesagt, vorteilhaft, während dieser Abscheidung noch C mit einer Konzentration von 1×10¹⁹ cm⁻³ bis 2×10²⁰ cm"3 einzubauen. Nach dieser Abscheidung wird auf der n⁺-dotierten Emitterschicht 60a,b noch ein dünne Nitridschicht 90 von etwa 20 nm aufgebracht und die resultierende Doppelschicht mittels einer Fototechnik anisotrop strukturiert.

Danach wird gemäß Fig. 2f mittels einer Fototechnik eine Lackmaske M um das p⁺-Polysilizium-Anschlussgebiet des DPSA-Transistors angebracht und mit einer Nassätzung die CVD-Oxidschicht 35" auf dem p⁺-Polysilizium (bis auf einen Restbereich unmittelbar neben dem Emitterfenster F) des Basisanschlusses 40 sowie die Oxidspacer 80 an den Aussenkanten des p⁺-Polysilizium des Basisanschlusses 40 sowie entsprechende Bereiche der CVD-Oxidschicht 35' entfernt. Dabei wird das nicht durch die Lackmaske M geschützte Teilgebiet der CVD-Isolation angeätzt.

Anschliessend wird gemäß Fig. 2g die Maske M entfernt und auf den freiliegenden Bereichen des p⁺-Polysiliziums des Basisanschlusses 40 eine Silizidschicht 95 erzeugt. Danach wird eine SiO2-Schicht abgeschieden und durch chemisch-mechanisches Polieren planarisiert, so dass eine ca. 1500 nm dicke Zwischenoxidschicht 100 entsteht. In diesem Zustand wird der oben im Zusammenhang mit Fig. 1b beschriebene Ausheilschritt zur Aktivierung des Dotierstoffs im n⁺-Emitterbereich durchgeführt (z.B. 980 °C, 5s). Dabei diffundiert der Dotierstoff aus dem monokristallinen n⁺-Emitterbereich 60b einige nm in die darunter liegende Si-Kappe 34 ein, um den in Fig. 2g nicht eingezeichneten monokristallinen Emitterbereich 31 (vgl. Fig. 1b) zu bilden. Fig. 2g zeigt den fertig gestellten DPSA-Transistor, bei dem noch W-Kontakte 96, 97, 98 vorgesehen sind, mit denen Leitungen 110, z.B. aus AlCu, verbunden sind.

Fig. 3a-g sind schematische Darstellungen der Verfahrensschritte einer erfindungsgemäßen Ausführungsform des Verfahrens zur Herstellung eines DPSA-Transistors.

Die Ausführungsform ist ein mittels ganzflächiger differentieller SiGe-Epitaxie hergestellter DPSA-Transistor.

Ein bekanntes Herstellungsverfahren für den mittels ganzflächiger differentieller SiGe-Basis-Epitaxie hergestellten DPSA-Transistor ist in der WO 02/061843 A1 ausführlich beschrieben. Es werden hier die zum Verständnis der Ausführungsform wichtigsten Herstellungsschritte beginnend mit der selektiven Basisabscheidung erläutert.

Von den in der WO 02/061843 A1 dargestellten Beispielen entspricht die Ausführungsform dem in den dortigen Fig. 10 bis Fig. 13 gezeigten Beispiel mit einem Innenspacer im Emitterfenster. Ein schematisches Querschnittsbild einer ähnlichen Transistorstruktur wird auch in der neueren Literatur dargestellt (siehe z.B. B. Jagannathan et al., IEEE Electron Device Letters, Vol. 23, 2002, S. 258-260).

Auf dem bereits im zweiten Anwendungsbeispiel in Fig. 2 beschriebenen CVD-Isolationsoxidbereich 35 mit dem eingebetteten n⁻-Kollektor 25 werden gemäß Fig. 3a in einem CVD-Reaktor mittels ganzflächiger differentieller SiGe/Si-Epitaxie die p⁺-dotierte SiGe-Basisschicht 120 und nachfolgend die niedrig dotierte Si-Kappenschicht 130 mit einer Dicke zwischen 10 und 40 nm abgeschieden. Ebenso wie im ersten Anwendungsbeispiel wird die Si-Ge-Schicht 120 während dieser Abscheidung mit einer C-Konzentration zwischen 1×10¹⁸ cm⁻³ und 1×10²⁰ cm⁻³ versehen. Während der Abscheidung wachsen die Schichten 120, 130 auf dem freiliegenden Siliziumbereich des n⁻-Kollektors 25 monokristallin und auf den Oxidbereichen 35 polykristallin auf (gestrichelte Linie in Fig. 3a). Die niedrig dotierte Si-Kappenschicht 130 kann dabei entweder n⁻- oder p⁻-dotiert sein. Dann werden gemäß Fig. 3b ganzflächig eine dünne CVD-Oxidschicht 140 und darüber eine Nitridschicht 150 abgeschieden. Mittels einer Fototechnik wird die Nitridschicht 150 anisotrop auf dem aktiven Transistorgebiet selektiv zur darunter liegenden CVD-Oxidschicht 140 strukturiert. Die so auf der CVD-Oxidschicht 140 entstandene Nitridmaske definiert das spätere Emitterfenster F.

Danach wird mit Bezug auf Fig. 3c die CVD-Oxidschicht 140 nasschemisch in den nicht von der Nitridmaske 150 abgedeckten Gebieten entfernt. In dem Beispiel in der WO 02/ 061843 A1 wird jetzt die freiliegende, niedrig dotierte p⁻-Si-Kappenschicht 130 nasschemisch und selektiv zur p⁺-dotierten SiGe-Basisschicht 120 entfernt. Dieser Schritt ist beim vorliegenden Ausführungsbeispiel nicht notwendig, da sie auch durch Ausdiffusion aus dem später anzubringenden p⁺-Basisanschluss umdotiert werden kann. Hierfür kann z.B. der Emitter-Aktivierungs-Temperaturschritt dienen bzw. kann vor dem späteren Aufbringen der n⁺-dotierten Emitterschicht ein zusätzlicher Temperaturschritt durchgeführt werden. Dabei schützt der in die SiGe-Basisschicht 120 eingebrachte Kohlenstoff (C) diese vor einer Ausdiffusion.

In diesem Ausführungsbeispiel wird die freiliegende niedrig dotierte p⁻-Si-Kappenschicht 130 nasschemisch von z.B. 20 nm auf 10 nm gedünnt, so dass diese Umdotierung sicher und ohne zusätzlichen Prozessaufwand z.B. mit dem späteren Emitter-Aktivierungs-Temperaturschritt erfolgt. Auf den nicht von der Nitridmaske abgedeckten Bereichen wird jetzt, wie in Fig. 3c gezeigt, in einem CVD Reaktor der Basisanschluss 160 mit 100-200 nm Dicke mittels selektiver Epitaxie in-situ p⁺-dotiert (> 1×10²⁰ cm⁻³) abgeschieden.

Dabei wächst er auf den monokristallinen Bereichen der p⁻-Si-Kappenschicht 130 monokristallin und auf den polykristallinen Bereichen der p⁻-Si-Kappenschicht 130 polykristallin auf. Dagegen findet bei diesen selektiven Abscheidebedingungen kein Wachstum auf der Nitridmaske 150 statt. Als nächstes wird ganzflächig eine CVD-Oxidschicht 170 mit einer Dicke von z.B. 200 nm abgeschieden.

Die so entstandene Struktur wird mittels eines CMP-Schrittes (CMP = chemical mechanical polishing) planarisiert, so dass die Nitridmaske 150 im Emitterfenster F freigelegt wird, wie in Fig. 3d gezeigt.

Danach werden mittels einer Fototechnik der den DPSA-Transistor umgebende Basisanschluss 160 einschliesslich der ihn abdeckenden CVD-Oxidschicht 170, der darunter liegenden p⁻-Si-Kappenschicht 130 und der darunter liegenden p⁺-SiGe-Basisschicht 120 anisotrop strukturiert. Als nächstes wird die Nitridmaske 150 im Emitterfenster F nasschemisch oder trockenchemisch selektiv zur darunter liegenden CVD-Oxidschicht 140 entfernt, und in bekannter Weise wird an den Seitenwänden des p⁺-dotierten Basisanschlusses 160 und der ihn abdeckenden CVD-Oxidschicht 170 ein Spacer 180 vorzugsweise aus Nitrid angebracht. Ein derartiger Spacer 180' wird im gleichen Schritt jeweils auch an der freigelegten Aussenseite der Schichten 120, 130, 160, 170 vorgesehen. Der entsprechende Prozesszustand ist in Fig. 3e gezeigt.

Jetzt wird gemäß Fig. 3f mittels einer Nassätzung die CVD-Oxidschicht am Boden des Emitterfensters F entfernt und so die p⁻-Si-Kappenschicht 130 im Emitterfenster F freigelegt.

Wie schon im zweiten Beispiel der Fig. 2 beschrieben, wird dann die n⁺-dotierte Emitterschicht 60a,b monokristallin mittels differentieller Epitaxie auf den aktiven Transistorbereich und polykristallin auf den umliegenden Bereich abgeschieden. Die weiteren Prozessschritte zur Fertigstellung dieses mittels ganzflächiger SiGe-Basisabscheidung hergestellten DPSA Transistors sind identisch zum zweiten Beispiel, wie in Fig. 2e-g beschrieben. Die fertige DPSA-Transistorstruktur gemäß der zweiten Ausführungsform ist in Fig. 3g dargestellt, worin 160' den ausdiffundierten Basisanschlussbereich bezeichnet.

### Bezugszeichenliste

- 25: Kollektorbereich
- 30: Basisbereich
- 35,35',35": Oxidschicht
- 40,160,160': Basisanschlussbereich
- 55',80,180,180': Oxid-Seitenwandspacer
- 60a,b 60a',b': mono-, polykristalline Emitterschicht
- F: Emitterfenster
- 1: Siliziumsubstrat
- 10: Subkollektorbereich
- 70,71: Nitridschicht
- 71a: Nitrid-Seitenwandspacer
- U: Überhang
- 32,120: Basisgrundschicht
- 34,130: Basiskappenschicht
- 90: Nitridmaske
- M: Fotomaske
- 100: Zwischendielektrikum
- 96, 97, 98: Kontakte
- 110: Verdrahtung
- 95: Silizid
- 140: Oxidschicht
- 150: Nitridschicht
- 170: Oxidschicht

## Patentansprüche

1. Verfahren zur Herstellung eines Bipolartransistors mit den Schritten:
Bereitstellen eines Halbleitersubstrats (1) mit einem darin eingebetteten, nach oben freiliegenden Kollektorbereich (25) eines ersten Leitungstyps (n);
Vorsehen eines monokristallinen Basisgrundbereichs (120) des zweiten Leitungstyps (p) und eines monokristallinen Basiskappenbereichs (130) des ersten oder zweiten Leitungstyps (n,p) als Basisbereich (120, 130) über dem Kollektorbereich (25), wobei der Basisbereich (120, 130) ganzflächig über dem Halbleitersubstrat (1) abgeschieden wird;
Vorsehen eines Basisanschlussbereichs (160) des zweiten Leitungstyps (p) über dem Basisbereich (120, 130);
Vorsehen eines ersten Isolationsbereichs (170) über dem Basisanschlussbereich (160);
Bilden eines Fensters (F) im ersten Isolationsbereich (170) und Basisanschlussbereich (160) zum zumindest teilweisen Freilegen des Basisbereichs (120, 130);
Vorsehen eines ersten isolierenden Seitenwandspacers (180) im Fenster zum Isolieren des Basisanschlussbereichs (160) ;
Entfernen eines natürlichen Oxids im freigelegten Basisbereich (120, 130);
differentielles Abscheiden und Strukturieren einer Emitterschicht (60a, 60b), welche oberhalb des Basisbereichs (120, 130) einen monokristallinen Emitterbereich (60a) und oberhalb des ersten Isolationsbereich (170) und des ersten Seitenwandspacers (180) einen polykristallinen Emitterbereich (60b) bildet; und
Durchführen eines Temperschritts zum teilweisen Eintreiben des monokristallinen Emitterbereichs (60a) in den Basisbereich (120, 130) und zum Bilden eines vergrößerten monokristallinen Emitterbereichs (60a'); und wobei
über dem Basisbereich (120, 130) ein Maskenbereich (140, 150) entsprechend dem späteren Fenster (F) gebildet wird, der in den Basisanschlussbereich (160) und den darüberliegenden ersten Isolationsbereich (170) eingebettet wird, wonach das Fenster (F) gebildet wird;
der Basisbereich (120, 130) als Basisgrundbereich (120) angrenzend an den Kollektorbereich (25) eine untere höher dotierte erste SiGe Basisgrundschicht (120) und als Basiskappenschicht (130) eine obere niedriger dotierte Si Basiskappenschicht (130) aufweist, über der der Basisanschlussbereich (160) vorgesehen ist, wobei die Basiskappenschicht (130) beim Temperschritt von dem Basisanschlussbereich (160) aufdotiert wird; und
der nach dem Bilden des Maskenbereichs (150) freiliegende Bereich der Basiskappenschicht (130) gedünnt wird.

2. Verfahren nach Anspruch 1, **dadurch gekennzeichnet, dass** in die Emitterschicht (60a, 60b) Kohlenstoff eingebaut wird.

3. Verfahren nach Anspruch 1 oder 2, **dadurch gekennzeichnet, dass** der Temperschritt ein schneller Annealschritt, vorzugsweise ein Lampenannealschritt, ist.

4. Verfahren nach Anspruch 1, **dadurch gekennzeichnet, dass** der Basisanschlussbereich (160) mittels selektiver Epitaxie in situ dotiert über dem Basisbereich (120, 130) aufgewachsen wird.

5. Verfahren nach Anspruch 1 oder 4, **dadurch gekennzeichnet, dass** der Maskenbereich (140, 150) eine Oxidschicht (140) und eine darüberliegende Nitridschicht (150) aufweist, die Nitridschicht (150) beim Bilden des Fensters (F) entfernt wird, der erste Seitenwandspacer (180) im Fenster (F) auf der Oxidschicht (140) gebildet wird, und dann die Oxidschicht (140) mittels einer nasschemischen Ätzung geöffnet wird.

6. Verfahren nach einem der vorherigen Ansprüche, **dadurch gekennzeichnet, dass** das Entfernen des natürlichen Oxids im freigelegten Basisbereich (120, 130) in einem Epitaxiereaktor durch eine Temperung in Wasserstoffatmosphäre geschieht und das differentielle Abscheiden der Emitterschicht (60a, 60b) anschließend in situ im Epitaxiereaktor durchgeführt wird.

## Claims

1. Method for the production of a bipolar transistor having the steps of:
providing a semiconductor substrate (1) with a collector region (25) of a first conduction type (n) embedded therein, said collector region being bare toward the top;
providing a monocrystalline base foundation region (120) of the second conduction type (p) and a monocrystalline base cap region (130) of the first or second conduction type (n, p) as a base region (120, 130) above the collector region (25), wherein the base region (120, 130) is deposited over the whole area of the semiconductor substrate (1)
providing a base terminal region (160) of the second conduction type (p) above the base region (120, 130);
providing a first insulation region (170) above the base terminal region (160);
forming a window (F) in the first insulation region (170) and base terminal region (160) for the purpose of at least partly uncovering the base region (120, 130);
providing a first insulating sidewall spacer (180) in the window for the purpose of insulating the base terminal region (160);
removing a natural oxide in the uncovered base region (120, 130);
differentially depositing and patterning an emitter layer (60a, 60b), which forms a monocrystalline emitter region (60a) above the base region (120, 130) and a polycrystalline emitter region (60a) above the first insulation region (170) and the first sidewall spacer (180); and
carrying out a heat treatment step for the purpose of partly driving the monocrystalline emitter region (60a) into the base region (120, 130) and for the purpose of forming an enlarged monocrystalline emitter region (60a'); and wherein a mask region (140, 150) is formed above the base region (120, 130) in accordance with the later window (F), said mask region being embedded in the base terminal region (160) and the overlying first insulation region (170), after which the window (F) is formed; the base region (120, 130) as base foundation region (120) bordering on the collector region (25) has a lower, more highly doped first SiGe base foundation layer (120) and as base cap layer (130) an upper, more lightly doped Si base cap layer (130), above which the base terminal region (160) is provided, the base cap layer (130) being doped upward during the heat treatment step from the base terminal region (160); and the base cap layer (130) that is uncovered after the formation of the mask region (150)is thinned.

2. Method according to Claim 1, **characterized in that** carbon is incorporated into the emitter layer (60a, 60b).

3. Method according to Claim 1 or 2, **characterized in that** the heat treatment step is a rapid annealing step, preferably a lamp annealing step.

4. Method according to Claim 1, **characterized in that** the base terminal region (160) is grown above the base region (120, 130) by means of selective epitaxy in a manner doped in situ.

5. Method according to Claim 1 or 4, **characterized in that** the mask region (140, 150) has an oxide layer (140) and an overlying nitride layer (150), the nitride layer (150) is removed during the formation of the window (F), the first sidewall spacer (180) is formed in the window (F) on the oxide layer (140), and then the oxide layer (140) is opened by means of a wet-chemical etching.

6. Method according to one of the preceding claims, **characterized**
**in that** the removal of the natural oxide in the uncovered base region (120, 130) takes place in an epitaxy reactor by means of a heat treatment in a hydrogen atmosphere and the differential deposition of the emitter layer (60a, 60b) is subsequently carried out in situ in the epitaxy reactor.

## Revendications

1. Procédé de production d'un transistor bipolaire, comprenant les stades :
on se procure un substrat (1) semi-conducteur, ayant une partie (25) de collecteur d'un premier type (n) de conductivité, qui y est incorporée et qui est à découvert vers le haut ;
on prévoit une région (120) de fond de base monocristalline du deuxième type (p) de conductivité et une région (130) de chapeau de base monocristalline du premier ou du deuxième type (n, p) de conductivité, comme région (120, 130) de base, au-dessus de la région (25) de collecteur, dans lequel on dépose la région (120, 130) de base, sur toute la surface, sur le substrat (1) semi-conducteur ;
on prévoit une région (160) de borne de base du deuxième type (p) de conductivité au-dessus de la région (120, 130) de base ;
on prévoit une première région (170) isolante au-dessus de la région (160) de borne de base ;
on forme une fenêtre (F) dans la première région (17) isolante et dans la région (160) de borne de base, pour la mise à découvert, au moins en partie, de la région (120, 130) de base ;
on prévoit un premier intercalaire (180) isolant de paroi latérale dans la fenêtre, pour isoler la partie (160) de borne de base ;
on élimine un oxyde naturel dans la partie (120, 130) de base mise à découvert ;
on dépose et on structure différentiellement une couche (60a, 60b) d'émetteur, qui forme, au-dessus de la région (120, 130) de base, une région (60a) d'émetteur monocristalline, et au-dessus de la première région (170) isolante et du premier intercalaire (180) de paroi latérale, une région (60b) d'émetteur polycristalline et
on effectue un stade de mise en température pour incorporer en partie la région (60a) d'émetteur monocristalline dans la région (120, 130) de base et pour former une région (60a') d'émetteur monocristalline agrandie et dans lequel
on forme, au-dessus de la région (120, 130) de base, une région (140, 150) de masque correspondant à la fenêtre (F) ultérieure, que l'on incorpore dans la région (160) de borne de base et dans la première région (170) isolante se trouvant au-dessus, grâce à quoi on forme la fenêtre (F) ;
la région (120, 130) de base, ayant comme région (120) de fond de base, au voisinage de la région (25) de collecteur, une première couche (120) de fond de base inférieure en SiGe à fort dopage et une région (130) de chapeau de base supérieure en Si peu dopée, au-dessus de laquelle la région (160) de borne de base est prévue, dans lequel on dope la couche (130) de chapeau de base lors du stade de mise en température, par la région (160) de borne de base et
on amincit la région mise à découvert après la formation de la région (150) de base de la couche (130) de chapeau de base.

2. Procédé suivant la revendication 1, **caractérisé en ce que** l'on incorpore du carbone dans la couche (60a, 60b) d'émetteur.

3. Procédé suivant la revendication 1 ou 2, **caractérisé en ce que** le stade de mise en température est un stade de recuit rapide, de préférence un stade de recuit au chalumeau.

4. Procédé suivant la revendication 1, **caractérisé en ce que** l'on fait croître, avec dopage in situ au-dessus de la région (120, 130) de base, la région (160) de borne de base, au moyen d'une épitaxie sélective.

5. Procédé suivant la revendication 1 ou 4, **caractérisé en ce que** la région (140, 150) de masque a une couche (140) d'oxyde et une couche (150) de nitrure au-dessus, on élimine la couche (150) de nitrure lors de la formation de la fenêtre (F), on forme le premier intercalaire (180) de paroi latérale dans la fenêtre (F) sur la couche (140) d'oxyde et on ouvre ensuite la couche (140) d'oxyde au moyen d'une attaque chimique en voie humide.

6. Procédé suivant l'une des revendications précédentes, **caractérisé en ce que** l'élimination de l'oxyde naturelle, dans la région (120, 130) de base mise à découvert, a lieu dans un réacteur d'épitaxie par mise à température en atmosphère d'hydrogène et on effectue le dépôt différentiel de la couche (60a, 60b) d'émetteur ensuite in situ dans le réacteur d'épitaxie.
